# EUROPEAN PATENT APPLICATION

(11) **EP 2 312 640 A2**
(43) Date of publication of application: **20.04.2011**
(21) Application number: 10013429.5
(22) Date of filing: 07.10.2010
(51) Int. Cl.: H01L 31/02, H01L 31/05

(54) **Photoelectric energy transducing apparatus**

(30) Priority: 16.10.2009 TW 098135060
(71) Applicant: NeoBulb Technologies, Inc., Bandar Seri Begawan (BN)
(72) Inventor: Chen, Jen-Shyan, Hsinchu City Taiwan 30046, R.O.C. (TW); Lin, Chung-Jen, Taipei Taiwan, R.O.C. (TW); Peng, Yun-Lin, Hsinchu County 311 Taiwan, R.O.C. (TW); Wen, Wei-Yeh, Jhbei City, Hsinchu County 302 Taiwan, R.O.C. (TW)
(74) Representative: Goddar, Heinz J.

(57) **Abstract**

The invention discloses a photoelectric energy transducing apparatus, which includes a photoelectric energy transducing module and a semiconductor switch. The photoelectric energy transducing module includes a photoelectric energy transducing semiconductor structure, a first positive electrode, and a negative electrode. The semiconductor switch includes a second positive electrode and a second negative electrode. The second positive electrode is electrically connected to the first negative electrode. The second negative electrode is electrically connected to the first positive electrode. When light radiates onto the photoelectric energy transducing semiconductor structure, an electromotive force is induced between the first positive electrode and the first negative electrode, and the electromotive force provides a reverse bias on the semiconductor switch so that the semiconductor switch is cut off. Thereby, when several photoelectric energy transducing apparatuses are used in series, the entire in-series circuit is still conductible even if one or some of the photoelectric energy transducing apparatuses are damaged.

## Description

### BACKGROUND OF THE INVENTION

### 1. Field of the invention

The present invention relates to a photoelectric energy transducing apparatus and, more particularly, to a photoelectric energy transducing apparatus having a semiconductor switch.

### 2. Description of the prior art

With the research on photoelectric characteristics of semiconductors, there have been cost-effectiveness solar cells available in the market. It mainly utilizes sunlight which radiates onto the PN junction of the semiconductor device to stimulate movable electrons and electronic holes which induce an electromotive force under the effect of the electric field built by the electrons and holes. If the PN-junction semiconductor connects a load to form a loop, the electromotive force will work on the load.

However, a single PN-junction semiconductor merely provides a few point volts of electromotive force, so multiple PN-junction semiconductors are often connected in series to get a higher electromotive force. But in fact, the life time of each PN-junction semiconductor is not constant, and the discrepancy in life time may be especially greater depending on practical environments, making it possible for the entire in-series circuit to fail even if only one PN-junction semiconductor is damaged.

Under the above condition which only one component is damaged, it causes most other workable components to become waste products, causes waste of resources, and is very unfavorable to the environmental protection. In addition, it also makes the in-series structure fails to become a stable power supply, so at best the in-series structure only serves as a supplementary which assists batteries so far.

Therefore, with the steadily increase in the efficiency, solar cells will gradually become cost-effective power supply units, so it is necessary to improve the circuit design in order to avoid the phenomenon of the afore-mentioned waste of resources.

### SUMMARY OF THE INVENTION

One scope of the invention is to provide a photoelectric energy transducing apparatus.

This photoelectric energy transducing apparatus is still able to form a close circuit to the external environment when its photoelectric energy transducing module is damaged by having a bypass circuit which utilizes a semiconductor switch. Furthermore, when several photoelectric energy transducing apparatuses are used in series, the entire in-series circuit is guaranteed to be conductible.

The photoelectric energy transducing apparatus of the invention includes a photoelectric energy transducing module and a semiconductor switch. The photoelectric energy transducing module includes a photoelectric energy transducing semiconductor structure, a first positive electrode, and a first negative electrode, wherein when light radiates onto the photoelectric energy transducing semiconductor structure, an electromotive force being induced between the first positive electrode to the first negative electrode. The semiconductor switch includes a second positive electrode and a second negative electrode. The second positive electrode is electrically connected to the first negative electrode, while the second negative electrode is electrically connected to the first positive electrode. The electromotive force provides a reverse bias on the semiconductor switch during operation of the photoelectric energy transducing semiconductor structure so that the semiconductor switch is cut off.

The photoelectric energy transducing semiconductor structure can be a solar cell semiconductor structure or be made of materials having photovoltaic effects. The semiconductor switch can be a diode, a bipolar transistor, or a field effect transistor.

The semiconductor switch and the photoelectric energy transducing module are connected in parallel to form the bypass circuit. When the photoelectric energy transducing module works normally, it provides a reverse bias on the semiconductor switch which is then cut off. When the photoelectric energy transducing module is open-circuited due to being damaged or unable to work normally, the semiconductor switch is turned on by a forward bias provided by other in-series photoelectric energy transducing apparatuses, which makes the photoelectric energy transducing apparatus still be conductible. Therefore, the entire in-series circuit still works normally instead of being abandoned or maintained even if certain photoelectric energy transducing module is damaged or unable to work normally somehow.

The advantage and spirit of the invention may be understood by the following recitations together with the appended drawings.

### BRIEF DESCRIPTION OF THE APPENDED DRAWINGS

FIG.1 illustrates a function block diagram of the photoelectric energy transducing apparatus according to an embodiment of the invention.
FIG.2 illustrates a circuit diagram based on FIG.1.
FIG.3 illustrates a circuit diagram of an embodiment in which several photoelectric energy transducing apparatuses are used in series.
FIG.4A and FIG.4B illustrate circuit diagrams of two photoelectric energy transducing apparatuses using different semiconductor switches.
FIG.5 illustrates a schematic diagram of the photoelectric energy transducing apparatus in the embodiment.
FIG.6A illustrates a cross-sectional diagram of the photoelectric energy transducing apparatus along X-X line in FIG.5.
FIG.6B illustrates a cross-sectional diagram of the photoelectric energy transducing apparatus according to another embodiment.
FIG.6C illustrates a cross-sectional diagram of the photoelectric energy transducing apparatus according to another embodiment.
FIG.7 illustrates a cross-sectional diagram of the photoelectric energy transducing apparatus according to another embodiment.
FIG.8 illustrates a cross-sectional diagram of the photoelectric energy transducing apparatus according to another embodiment.
FIG.9 illustrates a schematic diagram of another embodiment in which several photoelectric energy transducing apparatuses of the invention are integrated.

### DETAILED DESCRIPTION OF THE INVENTION

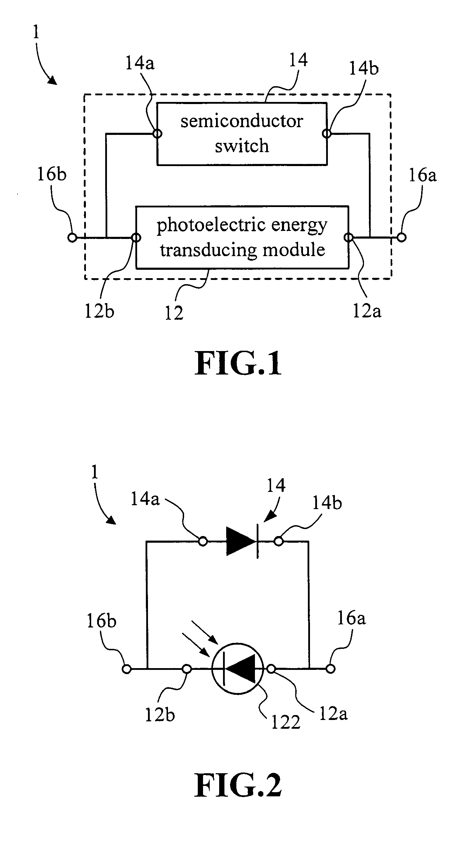

Please refer to FIG.1A which illustrates a function block diagram of the photoelectric energy transducing apparatus 1 according to an embodiment of the invention. The photoelectric energy transducing apparatus 1 of the invention mainly includes a photoelectric energy transducing module 12 and a semiconductor switch 14 connected in parallel. The photoelectric energy transducing module 12 has a first positive electrode 12a and a first negative electrode 12b. The semiconductor switch 14 includes a second positive electrode 14a and a second negative electrode 14b. The second positive electrode 14a is electrically connected to the first negative electrode12b, while the second negative electrode 14b is electrically connected to the first positive electrode 12a. In practical applications, the photoelectric energy transducing apparatus 1 usually uses the additional third positive electrode 16a and the third negative electrode 16b as an external electrical interface, wherein the third positive electrode 16a is electrically connected to the first positive electrode 12a, while the third negative electrode 16b is electrically connected to the first negative electrode 12b.

The photoelectric energy transducing module 12 includes a photoelectric energy transducing semiconductor structure 122 (see FIG.2) for transducing light energy to electricity and then applies power to the outside through the first positive electrode 12a and the first negative electrode 12b. In practical applications, the photoelectric energy transducing semiconductor structure can be a solar cell semiconductor structure or be made of materials having photovoltaic effects. The semiconductor switch 14 can be a diode, a bipolar transistor, or a field effect transistor, e.g. a Schottky diode; however, the present invention is not limited to the above embodiments.

Please refer to FIG.2 which illustrates a circuit diagram based on the function block diagram of FIG.1. During operation of the photoelectric energy transducing semiconductor structure 122 (e.g. a solar cell), a positive voltage is induced between the first positive electrode 12a and the first negative electrode 12b, so as to cut off the semiconductor switch 14 (e.g. a diode or a Schottky diode), parallel to the photoelectric energy transducing module 12, for being biased negatively. Thus, while the photoelectric energy transducing apparatus 1 is outputting power, the current flows through the third negative electrode 16b, the first negative electrode 12b, the photoelectric energy transducing semiconductor structure 122, the first positive electrode 12a, and the third positive electrode 16a; however, the current does not flow into the semiconductor switch 14 for it is cut off.

On the contrary, when the photoelectric energy transducing semiconductor structure 122 is unable to work normally somehow (e.g. being burned down, or having insufficient absorption light due to insufficient environment light or being sheltered) to generate the electromotive force, the current path formed by the third negative electrode 16b, the second positive electrode 14a, the semiconductor switch 14, the semiconductor switch 14 and the third positive electrode 16a can serve as a close circuit conditionally.

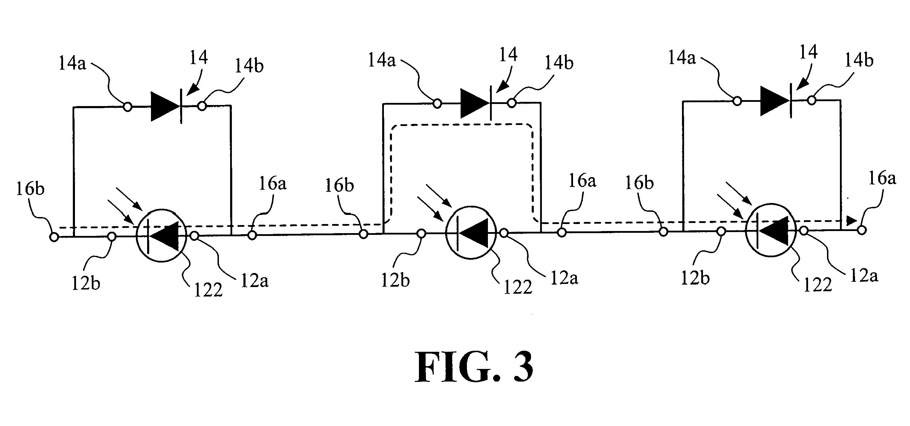

Taking FIG.3 which illustrates a circuit diagram of an embodiment in which several photoelectric energy transducing apparatuses 1 are used in series as an example, when the photoelectric energy transducing semiconductor structures 122 but the central one are able to work normally, the current path for outputting power is illustrated as the dotted line with an arrow. Since the semiconductor switch 14 of the central photoelectric energy transducing apparatus 1 can be biased positively by the left and right photoelectric energy transducing apparatuses 1, the current path still includes the central photoelectric energy transducing apparatus 1 by flowing through the semiconductor switch 14 in order to keep the in-series photoelectric energy transducing apparatus 1 outputting power.

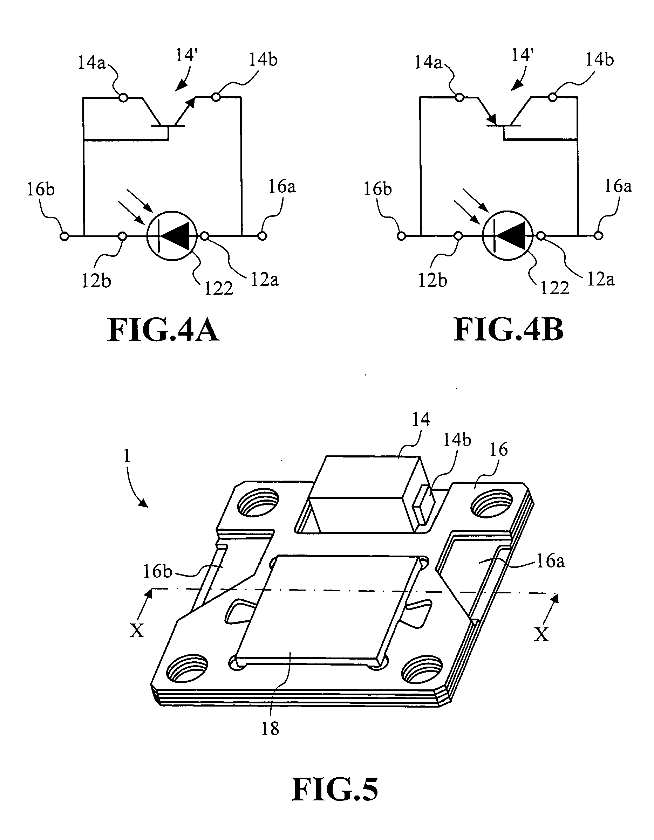

In brief, the photoelectric energy transducing apparatus of the invention is still able to form a close circuit to the outside conditionally by use of the bypass circuit even certain photoelectric energy transducing semiconductor structure is not effective. It further highlights the benefit of the invention in the application of several photoelectric energy transducing apparatuses used in series because the whole in-series photoelectric energy transducing apparatus is still able to work normally instead of replacing any element even if single or few photoelectric energy transducing semiconductor structures are not effective. It is additionally explained that the forgoing semiconductor switch 14 can be replaced with a bipolar transistor or a field effect transistor dependent on practical designs (see FIG.4A and FIG.4B). Besides, the photoelectric energy transducing semiconductor structure itself can be consisted of several arranged (series or parallel) solar cell semiconductor structures.

Please refer to FIG.5 which illustrates a schematic diagram of the photoelectric energy transducing apparatus 1 in the embodiment. The photoelectric energy transducing apparatus 1 uses the base 16 to hold the photoelectric energy transducing module 12 (not shown in FIG.5), the semiconductor switch 14, the transparent cover for protecting the photoelectric energy transducing module 12, etc. The base 16 is a laminated structure which not only forms a recess structure easily but also uses specific materials at different regions. For example, the lower portion of the base 16 requires to be heat-resistant because the photoelectric energy transducing module 12 produces high heat during operation; the upper portion of the base 16 can use other materials to reduce cost or increases the structural design elasticity of the base 16.

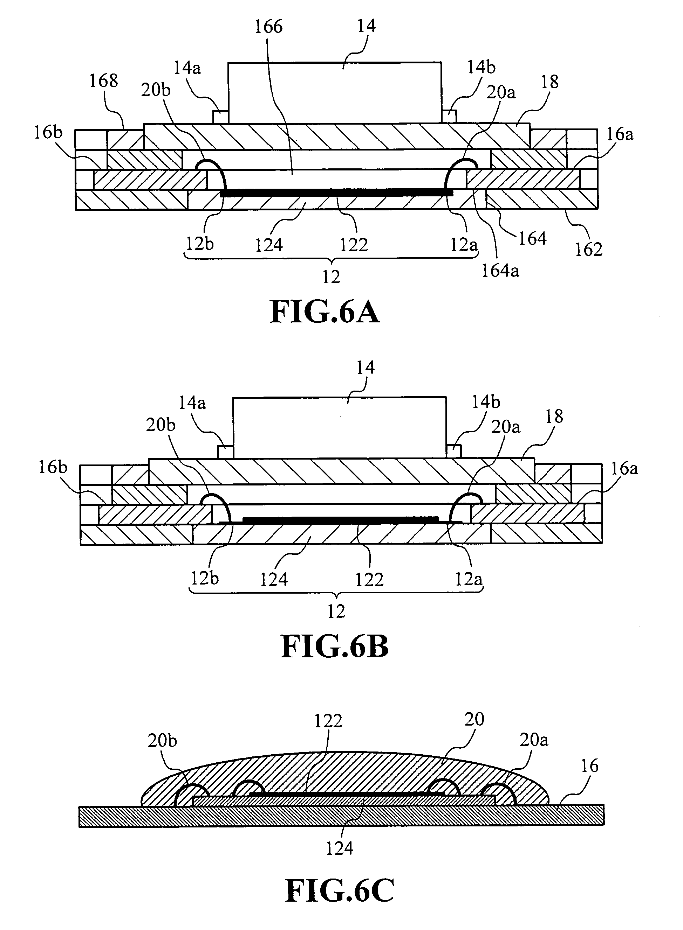

Please refer to FIG.6A which illustrates a cross-sectional diagram of the photoelectric energy transducing apparatus along X-X line in FIG.5. According to the embodiment, the photoelectric energy transducing module 12 includes a substrate 124 on which the photoelectric energy transducing semiconductor structures 122 is formed directly. Surely, the photoelectric energy transducing semiconductor structures 122 can be an independent solar cell chip disposed on the substrate 124 as shown in FIG.6B, wherein the substrate 124 can be a silicon substrate, a ceramic substrate, a printed circuit board or a metal substrate. The base 16 is composed of four plate-like matters, wherein the third layer from top to bottom has circuits thereon to connect each electrode; thus, the third layer can be a printed circuit board in order to facilitate the circuit layout, while the materials of other plate-like matters are determined based on practical production designs. In addition, the base 16 can be formed in one piece, e.g. a silicon base, a low temperature cofired ceramic (LTCC) base, or a printed circuit board.

The base 16 utilizes the laminated structures to form a recess portion 164 formed at a first (bottom) surface 162 of the base 16 easily; the base 16 also forms a through hole 166 forming through the bottom 164a of the recess portion 164 and a second surface 168 opposite to the first surface 162. The photoelectric energy transducing module 12 (or the substrate 124) is disposed within the recess portion 164 so that the photoelectric energy transducing semiconductor structures 122 is exposed in the through hole 166.

It is additionally explained that the base 16 does not necessarily have the through hole 166 and the transparent cover 18. The photoelectric energy transducing module 12 can be disposed directly on the base 16 and sealed by cencapsulants 20 for protection instead of the transparent cover 18, as shown in FIG.6C which does not illustrate the semiconductor switch 14. Surely, the transparent cover 18 can be disposed additionally on the structure in FIG.6C for further protection. A positive lens can be substituted for the transparent cover 18 to provide both the protection and light-focusing functions. Moreover, the base 16 must have the electric connection function. For instance, the base 16 can be a printed circuit board or a flexible circuit board, and thus the base can be etched to form the required lines; otherwise, conductive lines can be coated on other non-conductive coated circuit boards; otherwise, a flexible circuit board can be affixed to other plates (metallic conductors are feasible) to form a composite substrate.

In addition, since the portion of the base 16 which contacts the photoelectric energy transducing module 12 may be required to withstand a higher temperature without being affected, this portion can be made of the material which is heat-resistant and has lower expansion coefficient to provide a more stable base structure. Such base may be a silicon base or a low temperature cofired ceramic (LTCC) base.

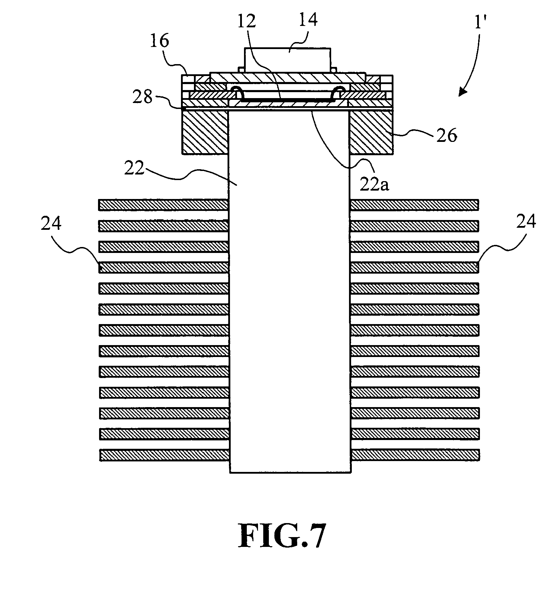

Please refer to FIG.7 which illustrates a cross-sectional diagram of the photoelectric energy transducing apparatus 1' according to another embodiment, wherein the cross-section of the heat pipe 22 is not shown. The photoelectric energy transducing apparatus 1' further includes a heaet dissipating module having the heat pipe 22 surrounded by plural heat dissipating fins 24, the heat pipe having a flat plane on which the base is disposed. One end of the heat pipe 22 has a flat plane 22a on which the photoelectric energy transducing module 12 (or the substrate 124) is disposed. To increase the engagement stability between the photoelectric energy transducing module 12 and the heat pipe 22, a fixing base 26 connects the end of the heat pipe 22, and the base 16 is fixed on the fixing base 26 by screws or in other ways; furthermore, in order to increase the thermal conductive efficiency, i.e. to decrease the thermal resistance, between the photoelectric energy transducing module 12 (or its substrate 124) and the flat plane 22a of the heat pipe 22, thermal phase change materials 28 are filled between the substrate 124 and the flat plane 22a to diminish the air space between the substrate 124 and the flat plane 22a to further increase the thermal conductive efficiency. In another embodiment, the photoelectric energy transducing semiconductor structure can be a solar cell chip directly attached to the heat pipe by the thermal phase change materials (otherwise, the photoelectric energy transducing semiconductor structure is disposed on a holding plate disposed at the recess portion of the base), so as to dissipate the heat generated from the photoelectric energy transducing semiconductor structure into the air through the heat pipe and the heat dissipating fins 24.

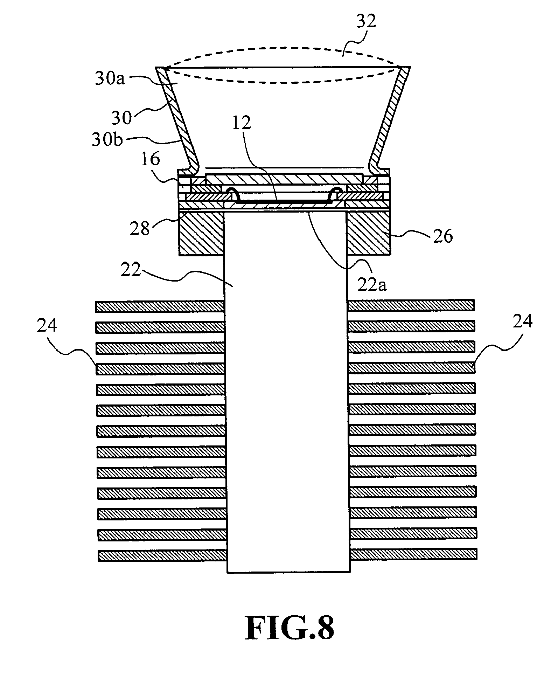

Please refer to FIG.8 which illustrates a cross-sectional diagram of the photoelectric energy transducing apparatus according to another embodiment. What is different from the photoelectric energy transducing apparatus 1' is that the photoelectric energy transducing apparatus in FIG.8 further includes a light collecting device for collecting light in the photoelectric energy transducing semiconductor structure 122. The light collecting device in FIG.8 includes a light collecting cup 30 disposed on the base 16. The inner surface 30a of the light collecting cup 30 may be coated with light reflection materials to enhance the light collecting effect. The outer surface 30b of the light collecting cup 30 may be coated with heat-insulating materials to reduce heat conduction of the heat adsorbed by the inner side or the set of the light collecting cup to the outer side of the light collecting cup 30 to affect other components, especially electronic components.

In addition, FIG.8 does not illustrate the semiconductor switch 14 because the semiconductor switch 14 is covered by the light collecting cup 30; in other words, the photoelectric energy transducing semiconductor structure 122 is inside the light collecting cup 30, while the semiconductor switch 14 is outside the light collecting cup 30. Thus, heat generated during operation of the photoelectric energy transducing semiconductor structure 122 is not conducted to the semiconductor switch 14; besides, light reflected from the photoelectric energy transducing semiconductor structure 122 (especially there is the transparent cover 18 thereon) does not radiate onto the semiconductor switch 14. To sum up the above two conditions, the light collecting cup 30 provides the heat-insulating function. Moreover, to increase the light collecting effect, a positive lens 32 may be disposed additionally at the opening of the light collecting cup 30 as illustrated by the dotted line. Surely, the positive lens 32 may be disposed independently and not get along with the light collecting cup 30 necessarily, but it has to consider the support of the positive lens 32, e.g. using several stands for support.

It is worth mentioning that by use of the light collecting cup 30 even plus the positive lens 32, the generated heat in the operation of the photoelectric energy transducing semiconductor structure 122 is quite amazing, so the photoelectric energy transducing semiconductor structure 122 sometimes is difficult to avoid being burned down; under this condition, the bypass circuit design of the present invention is more beneficial practically. At the same time, the semiconductor switch 14 is also an electronic component vulnerable to temperature; in order to maintain the work of other electronic components inclusive of the semiconductor switch 14, it is also essential for the light collecting cup 30 to have the heat-insulating function.

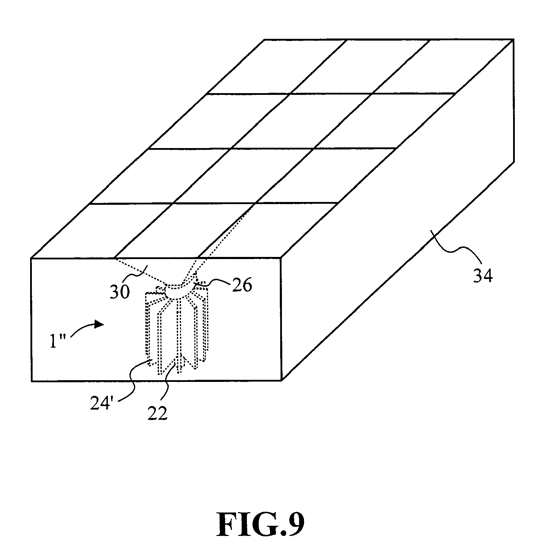

Please refer to FIG.9 which illustrates a schematic diagram of another embodiment in which several photoelectric energy transducing apparatuses 1" of the invention are integrated, wherein the portion of the photoelectric energy transducing apparatuses 1" inside the casing 34 is drew in the dotted line. In FIG.9, the casing 34 (or maybe a frame) is used to integrate (or receive) several photoelectric energy transducing apparatuses 1", mainly using (the light collecting cup 30 of) the light collecting devices used to fix the photoelectric energy transducing apparatuses 1" to achieve the purpose of mechanical integration and even the purpose of electrical integration by arranging the photoelectric energy transducing apparatuses 1" in series and parallel. Traditionally, the entire in-series structure will fails to work easily if certain solar cell unit is out of order; however, since the photoelectric energy transducing apparatus of the invention has the bypass circuit design, the entire in-series structure still works normally even if certain unit of photoelectric energy transducing semiconductor structure fails. The actuation mechanism is as mentioned above and not described again herein.

In addition, the photoelectric energy transducing apparatus 1" in FIG.9 is similar to that in Fit.8, but what the main difference is that the heat dissipating fins 24' extends in the axial direction of the heat pipe 22, while the heat dissipating fins 24 in FIG.8 (or FIG.7) extends in the radial direction of the heat pipe 22. In addition, the light collecting cup 30 in FIG.9 is, but not limited to, rectangular; if adapted to the round shape of a general positive lens, the light collecting cup 30 may also have a round shape to engage with the positive lens easily.

With the example and explanations above, the features and spirits of the invention will be hopefully well described. Those skilled in the art will readily observe that numerous modifications and alterations of the device may be made while retaining the teaching of the invention. Accordingly, the above disclosure should be construed as limited only by the metes and bounds of the appended claims.

## Claims

1. A photoelectric energy transducing apparatus, comprising:
a photoelectric energy transducing module comprising a photoelectric energy transducing semiconductor structure, a first positive electrode, and a negative electrode, wherein when light radiates onto the photoelectric energy transducing semiconductor structure, an electromotive force being induced between the first positive electrode and the first negative electrode;
a semiconductor switch comprising a second positive electrode and a second negative electrode, the second positive electrode being electrically connected to the first negative electrode, the second negative electrode being electrically connected to the first positive electrode, the electromotive force providing a reverse bias on the semiconductor switch during operation of the photoelectric energy transducing semiconductor structure so that the semiconductor switch is cut off; and
a base for holding the photoelectric energy transducing module and the semiconductor switch, the base comprising a third positive electrode and a third negative electrode, the third positive electrode being electrically connected to the first positive electrode, the third negative electrode being electrically connected to the first negative electrode;
wherein the base has a first surface, a second surface opposite to the first surface, a recess portion formed at the first surface, and a through hole forming through the bottom of the recess portion and the second surface, the photoelectric energy transducing module is disposed within the recess portion so that the photoelectric energy transducing semiconductor structure is toward the second surface and exposed in the through hole.

2. The apparatus of claim 1, wherein the photoelectric energy transducing semiconductor structure is a solar cell semiconductor structure.

3. The apparatus of claim 1, wherein the semiconductor switch is a diode, a bipolar transistor, or a field effect transistor.

4. The apparatus of claim 1, wherein the semiconductor switch is a Schottky diode.

5. The apparatus of claim 1, further comprising a heat dissipating module comprising a heat pipe surrounded by plural heat dissipating fins, the heat pipe having a flat plane on which the base is disposed.

6. The apparatus of claim 5, wherein the photoelectric energy transducing semiconductor structure and the flat plane of the heat pipe are attached to each other by thermal phase change materials.

7. The apparatus of claim 5, wherein the base is a silicon base, a low temperature cofired ceramic (LTCC) base, or a printed circuit board.

8. The apparatus of claim 1, further comprising a light collecting device, disposed on the base, for collecting light in the photoelectric energy transducing semiconductor structure.

9. The apparatus of claim 8, wherein the light collecting device comprises a light collecting cup, the photoelectric energy transducing semiconductor structure is inside the light collecting cup, the semiconductor switch is outside the light collecting cup.

10. The apparatus of claim 9, wherein the outer surface of the light collecting cup is coated with heat-insulating materials.

11. The apparatus of claim 10, wherein the light collecting device comprises a positive lens.

12. A photoelectric energy transducing apparatus, comprising:
a photoelectric energy transducing module comprising a photoelectric energy transducing semiconductor structure, a first positive electrode, and a negative electrode, wherein when light radiates onto the photoelectric energy transducing semiconductor structure, an electromotive force being induced between the first positive electrode and the first negative electrode, wherein the photoelectric energy transducing module comprises a substrate on which the photoelectric energy transducing semiconductor structure is disposed;
a semiconductor switch comprising a second positive electrode and a second negative electrode, the second positive electrode being electrically connected to the first negative electrode, the second negative electrode being electrically connected to the first positive electrode, the electromotive force providing a reverse bias on the semiconductor switch during operation of the photoelectric energy transducing semiconductor structure so that the semiconductor switch is cut off; and
a heat dissipating module comprising a heat pipe surrounded by plural heat dissipating fins, the heat pipe having a flat plane on which the substrate is disposed.

13. The apparatus of claim 12, wherein the substrate is a silicon substrate, a ceramic substrate, a printed circuit board or a metal substrate.

14. The apparatus of claim 12, wherein the semiconductor switch is disposed on the substrate.

15. The apparatus of claim 12, further comprising thermal phase change materials disposed between the substrate and the flat plane of the heat pipe.

16. The apparatus of claim 12, further comprising a light collecting device, disposed on the substrate, for collecting light in the photoelectric energy transducing semiconductor structure.

17. The apparatus of claim 16, wherein the light collecting device comprises a light collecting cup, the photoelectric energy transducing semiconductor structure is inside the light collecting cup, the semiconductor switch is outside the light collecting cup.

18. The apparatus of claim 17, wherein the outer surface of the light collecting cup is coated with heat-insulating materials.

19. The apparatus of claim 18, wherein the light collecting device comprises a positive lens.
